# EUROPEAN PATENT SPECIFICATION

(11) **EP 2 525 233 B1**
(45) Date of publication and mention of the grant of the patent: **28.03.2018**
(21) Application number: 12168563.0
(22) Date of filing: 18.05.2012
(51) Int. Cl.: G01R 33/483, G01R 33/563

(54) **Spatially non-uniform presaturation of the imaging region in time-of-flight magnetic resonance angiography**
Räumlich ungleichmässige Vorsättigung der Bildgebungsregion in der Flugzeit-Magnetresonanzangiographie
Présaturation spatialement inhomogène de la région d'imagerie dans l'angiographie par résonance magnétique à temps de vol

(30) Priority: 20.05.2011 US 201113112349; 20.04.2012 JP 2012097123
(43) Date of publication of application: 21.11.2012
(73) Proprietor: Toshiba Medical Systems Corporation, Otawara-shi, Tochigi-ken 324-8550 (JP)
(72) Inventor: Wheaton, Andrew J., Tochigi 324-8550 (JP); Dannels, Wayne R., Tochigi 324-8550 (JP)
(74) Representative: Moreland, David

(56) References cited:
- WO-A1-2009/015348
- US-A1- 2003 160 611
- US-A1- 2010 226 556
- TETSUYA MATSUDA ET AL: "AN ASYMMETRIC SLICE PROFILE: SPATIAL ALTERATION OF FLOW SIGNAL RESPONSE IN 3D TIME-OF-FLIGHT NMR ANGIOGRAPHY", MAGNETIC RESONANCE IN MEDICINE, ACADEMIC PRESS, DULUTH, MN, US, vol. 29, no. 6, 1 June 1993 (1993-06-01), pages 783-789, XP000369762, ISSN: 0740-3194
- EDELMAN R R ET AL: "Quantification of Blood Flow with Dynamic MR Imaging and Presaturation Bolus Tracking", RADIOLOGY, RADIOLOGICAL SOCIETY OF NORTH AMERICA, OAK BROOK,IL, US, vol. 171, 1 January 1989 (1989-01-01), pages 551-556, XP002481393, ISSN: 0033-8419
- TYSZKA M ET AL: "AUTOMATIC ANALYSIS OF TAGGED IMAGES OF LAMINAR FLUID FLOW", JOURNAL OF MAGNETIC RESONANCE, ACADEMIC PRESS, ORLANDO, FL, US, vol. 97, no. 2, 1 April 1992 (1992-04-01), pages 391-397, XP000275064, ISSN: 1090-7807
- ROBERT R. EDELMAN ET AL: "Quiescent-interval single-shot unenhanced magnetic resonance angiography of peripheral vascular disease: Technical considerations and clinical feasibility", MAGNETIC RESONANCE IN MEDICINE, vol. 63, no. 4, 1 April 2010 (2010-04-01), pages 951-958, XP55034595, ISSN: 0740-3194, DOI: 10.1002/mrm.22287
- YU LIU ET AL: "MAGNETIZATION-PREPARED CARDIAC IMAGING USING GRADIENT ECHO ACQUISITION", MAGNETIC RESONANCE IN MEDICINE, ACADEMIC PRESS, DULUTH, MN, US, vol. 30, no. 2, 1 August 1993 (1993-08-01) , pages 271-275, XP000385362, ISSN: 0740-3194
- K.J. JUNG ET AL: "Artifacts due to Reverse Flow in the Artery and Their Correction in TOF Angiography with Presaturation of the Vein", PROC.INTL.SOC.MAG.RESON.MED., 1 January 2000 (2000-01-01), page 1826, XP55034598,

## Description

### FIELD

Embodiments described herein relate generally to a magnetic resonance imaging apparatus and a magnetic resonance imaging method.

### BACKGROUND

Conventionally, a magnetic resonance imaging (MRI) apparatus processes imaging by utilizing nuclear magnetic resonance (NMR) effects. Recent years, the MRI apparatus acquires an image of vasculature by utilizing non-contrast magnetic resonance (MR) such as MR angiography (MRA) and/or MR venography (MRV).

Edelman R R et al: "Quantification of Blood Flow with Dynamic MR Imaging and Presaturation Bolus Tracking", Radiology, Radiological Society of North America, Oak Brook, IL, US, vol. 171, 1 January 1989 (1989-01-01), pages 551-556 discloses a method of quantifying blood flow using presaturation bolus tracking wherein the flip angle of 90° is used for the presaturation pulse.

Robert R Edelman et al: "Quiescent-interval single-shot unenhanced magnetic resonance angiography of peripheral vascular disease: Technical considerations and clinical feasibility" Magnetic Resonance in Medicine, vol. 63, no. 4, 1 April 2010 (1010-04-01), pages 951-958 discloses a magnetic resonance angiography technique that uses a slice-selective saturation RF pulse that is applied to the imaging slice to set the longitudinal magnetisation of tissues within the slice to zero.

US 2003/0160611 discloses a further imaging technique using spatially uniform presaturation pulses.

Tetsuya Matsuda et al: "An asymmetric slice profile: spatial alteration of flow signal response in 3D time-of-flight NMR angiography", Magnetic Resonance in Medicine, Academic vol. 29, no. 6, 1 June 1993 (1993-06-01) page 783-789 discloses a technique in which a presaturation pulse is located outside of an imaging slice.

US 2010/0226556 discloses an imaging technique in which a presaturation pulse is applied outside of an in-flow slide of an imaging slice.

According to the present invention there is provided a magnetic resonance imaging apparatus as claimed in Claim 1 and a magnetic resonance imaging method as claimed in Claim 8.

### BRIEF DESCRIPTION OF THE DRAWINGS

FIG. 1 is a high-level schematic block diagram of an exemplary MRI system embodiment adapted to acquire and process data for enhanced non-contrast MRA and/or MRV imaging of NMR nuclei in-flowing to a selected spatial region that has previously been subjected to spatially non-uniform degrees of saturation within that region;
FIG. 2 is a schematic representation of a typical non-contrast QISS (quiescent interval single shot) MRI sequence using a modified pre-saturation pulse having a non-uniform profile in the spatial domain across the selected image slice;
FIG. 3 schematically illustrates a pre-saturation pulse profile in the spatial domain having lesser saturation near the in-flow edge of the imaged slice and greater saturation near the out-flow edge of the imaged slice;
FIGS. 4A-4D schematically illustrate examples of a few possible pre-saturation profiles in the spatial domain across the slice to be imaged;
FIGS. 5A-5B depict simulated examples of vessel signal and relative signal improvement (as compared to a uniform conventional profile) for blood flow as a function of velocity using differently shaped pre-saturation profiles;
FIGS. 6A-6B depict simulated vessel signal and relative signal improvement (as compared to a uniform conventional profile) as a function of slice thickness for relatively slow-flowing blood;
FIGS. 7A-7B depict simulated vessel signal and relative signal improvement (as compared to a uniform conventional profile) as a function of the quiescent interval in a QISS MRA sequence for relatively slow-flowing blood and differently shaped pre-saturation profiles; and
FIGS. 8A-8B depict and compare actual images using (a) a conventional rectangular uniform saturation profile and (b) a ramp-shaped non-uniform saturation profile (for relatively fast-moving blood flows).

### DETAILED DESCRIPTION

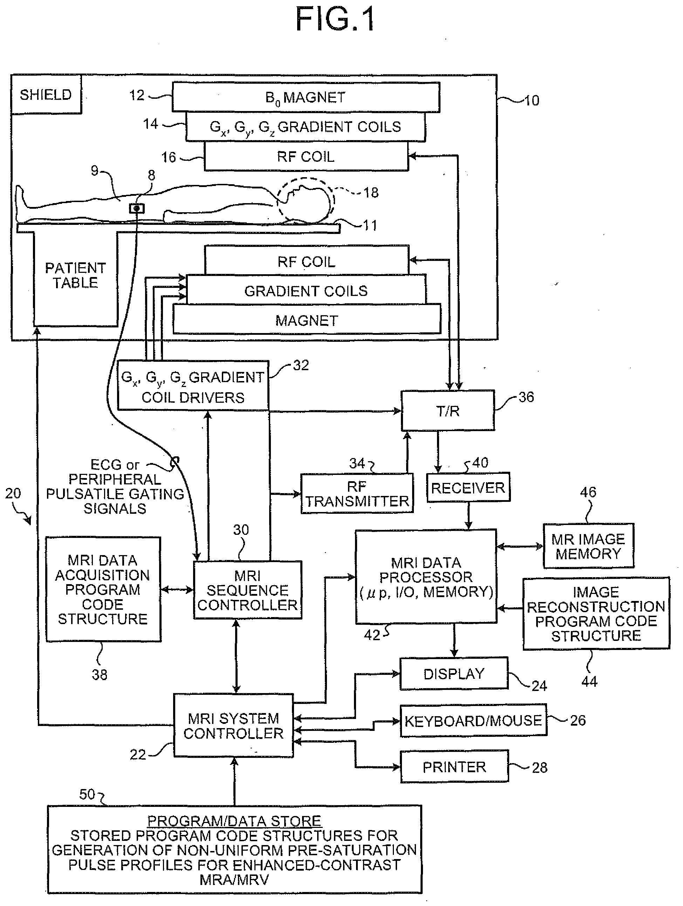

A magnetic resonance imaging apparatus according to the embodiment (hereinafter, "The MRI system" as appropriate) shown in FIG. 1 includes a gantry 10 (shown in schematic cross-section) and various related system components 20 interfaced therewith. At least the gantry 10 is typically located in a shielded room. One MRI system geometry depicted in FIG. 1 includes a substantially coaxial cylindrical arrangement of the static field B0 magnet 12, a Gₓ, G_{y} and G_{z} gradient coil set 14 and an RF coil assembly 16. Along the horizontal axis of this cylindrical array of elements is an imaging volume 18 shown as substantially encompassing the head of a patient 9 supported by a patient bed or table 11. As will be understood, various RF coil structures and/or coil arrays may be used for transmitting and/or receiving RF signals to/from the imaging volume 18.

An MRI system controller 22 has input/output ports connected to display 24, keyboard/mouse 26 and printer 28. As will be appreciated, the display 24 may be of the touch-screen variety so that it provides control inputs as well.

The MRI system controller 22 interfaces with MRI sequence controller 30 which, in turn, controls the Gₓ, G_{y} and G_{z} gradient coil drivers 32, as well as the RF transmitter 34 and the transmit/receive switch 36 (if the same RF coil is used for both transmission and reception). As those in the art will appreciate, one or more suitable physiological transducers 8 may be affixed to the patient's body to provide ECG (electrocardiogram) and/or peripheral pulsatile gating signals to the MRI sequence controller 30. The MRI sequence controller 30 also has access to suitable program code structure 38 for implementing MRI data acquisition sequences already available in the repertoire of the MRI sequence controller 30 - e.g., to generate non-contrast MRA (magnetic resonance angiography) and/or MRV (magnetic resonance venography) images using operator and/or system inputs defining particular MRI data acquisition sequence parameters.

The MRI system 20 includes an RF receiver 40 providing input to data processor 42 so as to create processed image data to display 24. The MRI data processor 42 is also configured for access to image reconstruction program code structure 44 and to MR (magnetic resonance) image memory 46 (e.g., for storing MR image data derived from processing in accordance with the exemplary embodiments and the image reconstruction program code structure 44).

Also illustrated in FIG. 1 is a generalized depiction of an MRl system program/data store 50 where stored program code structures (e.g., for generation of non-uniform pre-saturation pulse profiles for enhanced non-contrast MRA and/or MRV images, for accepting operator inputs to control same, etc.) are stored in computer-readable storage media accessible to the various data processing components of the MRI system. As those in the art will appreciate, the program store 50 may be segmented and directly connected, at least in part, to different ones of the system 20 processing computers having most immediate need for such stored program code structures in their normal operation (i.e., rather than being commonly stored and connected directly to the MRI system controller 22).

Indeed, as those in the art will appreciate, the FIG. 1 depiction is a very high-level simplified diagram of a typical MRI system with some modifications so as to practice exemplary embodiments to be described hereinbelow. The system components can be divided into different logical collections of "boxes" and typically comprise numerous digital signal processors (DSP), microprocessors, special purpose processing circuits (e.g., for fast A/D conversions, fast Fourier transforming, array processing, etc.). Each of those processors is typically a clocked "state machine" wherein the physical data processing circuits progress from one physical state to another upon the occurrence of each clock cycle (or predetermined number of clock cycles).

Not only does the physical state of processing circuits (e.g., CPUs, registers, buffers, arithmetic units, etc.) progressively change from one clock cycle to another during the course of operation, the physical state of associated data storage media (e.g., bit storage sites in magnetic storage media) is transformed from one state to another during operation of such a system. For example, at the conclusion of an MR-imaging reconstruction process, an array of computer-readable accessible data value storage sites (e.g., multi-digit binary representations of pixel values) in physical storage media will be transformed from some prior state (e.g., all uniform "zero" values or all "one" values) to a new state wherein the physical states at the physical sites of such an array (e.g., of pixel values) vary between minimum and maximum values to represent real world physical events and conditions (e.g., the tissues of a patient over an imaged volume space). As those in the art will appreciate, such arrays of stored data values represent and also constitute a physical structure - as does a particular structure of computer control program codes that, when sequentially loaded into instruction registers and executed by one or more CPUs of the MRI system 20, cause a particular sequence of operational states to occur and be transitioned through within the MRI system.

The exemplary embodiments described below provide improved ways to acquire and/or process MRI data acquisitions and/or to generate and display MR images.

The MRI system according to the embodiment includes an acquisition unit and an image reconstruction unit. The acquisition unit acquires a signal from an area in which a fluid flows by spatially non-uniformly applying a saturation pulse (hereinafter, "pre-saturation pulse" as appropriate) that saturates longitudinal magnetization of a proton to an area and by applying an excitation pulse to the area when a predetermined time has passed after the application of the pre-saturation pulse. The image reconstruction unit reconstructs an image indicating the fluid by using the acquired signal. The acquisition unit according to the embodiment spatially non-uniformly applies a pre-saturation pulse to the area by changing the flip angle of the pre-saturation pulse along the flow direction in which the fluid flows in the area. Although illustration is omitted, it is satisfactory if, for example, the MRI sequence controller 30 includes the acquisition unit and the MRI data processor 42 includes the image reconstruction unit.

A general class of non-contrast MRA techniques generate white blood angiography images by saturating background tissue in an intended image slice region and thereafter allowing "fresh" (i.e., unsaturated) in-flowing blood to appear bright (high signal) in a subsequently acquired MR image of the image slice region. Time-of-Flight (TOF) MRI is one example of such a technique.

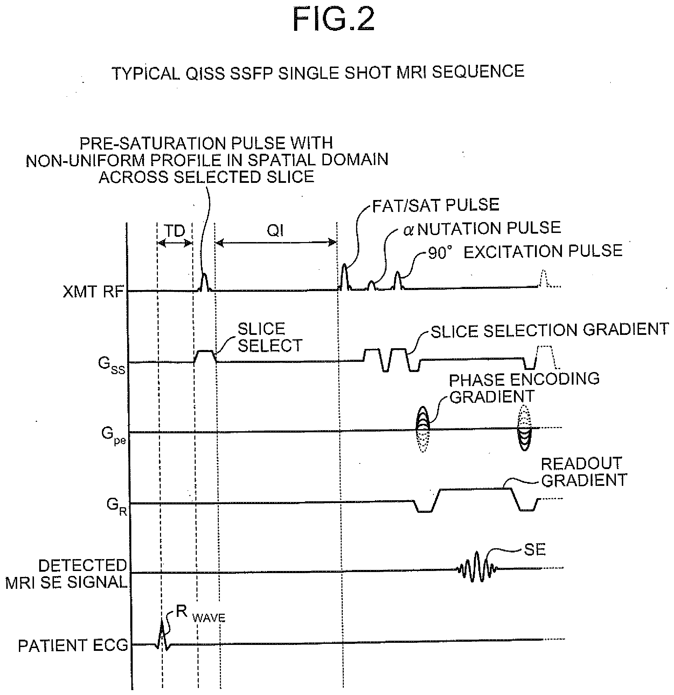

A variant of TOF, called Quiescent Interval Single Shot (QISS) is depicted schematically in FIG. 2. In FIG. 2, α nutation pulse is unnecessary. QISS applies a spatially selective pre-saturation pulse directly on the image slice of interest. The effect of the on-slice saturation is to immediately generate background suppression in the slice of interest. During a "quiescent interval" (QI) fresh non-saturated blood is allowed to flow into the slice of interest. The QI typically is chosen to be approximately 200-300 ms, i.e., long enough to allow sufficient in-flow of fresh blood, but short enough to prevent substantial T1 NMR recovery of the previously saturated background tissue. After the QI, the magnetization of fresh in-flow blood is detected using conventional MRI pulse sequence(s), e.g., a 2D readout such as SSFP (steady-state free precession). To save scan time, the readout is typically performed in a "single shot". As will be appreciated, during each "single shot," one or more different magnitudes of phase encoding are employed so as to acquire data during that shot for a corresponding part of k-space. To make the scan into an arteriogram, venous blood can be saturated using a separate "walking" (i.e., sequentially moved) spatially selective pre-saturation pulse, as is commonly applied in TOF2D.

The on-slice spatially selective pre-saturation is effective at reducing background tissue signal. However, it also saturates blood then disposed within the slice of interest. For blood flow with relatively slow velocity, such as the blood near the edges of a vessel with laminar flow or blood in small arterioles, the QI is typically not long enough to allow complete refreshment of blood within the slice during a typical MRI data acquisition pulse sequence. Some residual saturated slow-flowing blood may thus still be in the slice at the time of MRI data acquisition, thereby resulting in undesirable signal loss. This same problem gets worse with thicker slices and/or a shorter QI.

The consequences of this problem are numerous. First, and most importantly, the MRI signal emanating from small vessels may be severely diminished, often to the point where it is absent in the final image. The signal from the edges of larger vessels (with slow velocity in the case of laminar flow) is also decreased, thereby reducing their apparent lumen width and resulting in possible over-estimation of stenosis.

The second problem is that the QI often must be carefully chosen to allow sufficient in-flow while reducing background signal. If the quiescent interval is long relative to the T1 NMR relaxation time of background tissue, undesirable background signal can increase and reduce conspicuity of the vessels to be imaged. This problem is most prevalent for fat nuclei since QI is often on the order of fat T1 (e.g., -250 ms).

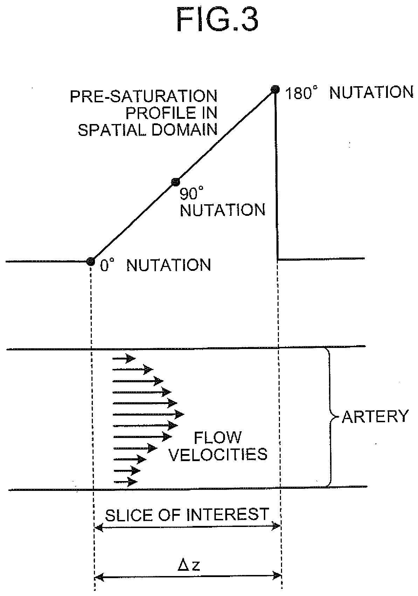

An exemplary embodiment described below modifies the spatial profile of the pre-saturation pulse in a non-contrast MRI (e.g., MRA and/or MRV) sequence to address at least some of the above-discussed disadvantages. For example, the acquisition unit according to the embodiment spatially non-uniformly applies a pre-saturation pulse to a slice such that the flip angle of the pre-saturation pulse on a flow-in side where blood flows into the slice is less than the flip angle of the pre-saturation pulse on a flow-out side where the blood flows out of the slice. The pre-saturation spatial profile of the pulse can be "shaped" to selectively saturate to a greater degree near an "out-flow edge" of the slice of interest and selectively saturate less near the "in-flow edge" of the slice as shown in FIG. 3. For example, the pre-saturation pulse can be designed to generate a ramped spatial profile, similar to a TONE (tilt optimized non-saturated excitation) pulse or other shaped spatial profile RF excitation pulses, with minimal flip angle near the in-flow edge and maximum flip angle near the out-flow edge. In general, the time domain envelope of a spatially selective RF NMR pulse is related to the spatial domain profile by a Fourier Transformation (FT). For example, a typical RF excitation pulse is given a sinc-shaped time domain envelope because, after Fourier Transformation, this becomes square wave in the spatial domain with a uniform spatial domain profile. Similarly, inverse Fourier Transformation (FT⁻¹) of the desired spatial domain profile can be used to define a corresponding time domain RF pulse envelope shape.

Flowing spins starting at the arterial in-flow edge of the Δz-thick image slice of interest (left hand side in FIG. 3) take the longest time to exit the slice (and be replaced by fresh in-flow magnetization). By using a spatially shaped pre-saturation pulse, these spins are only partially saturated (or possibly not at all). Thus, if they are slow and are still within the slice after QI at image capture time, they can still contribute signal to the final image. The spins near the out-flow edge of the slice are more strongly saturated during pre-saturation. However, they have less distance to travel to exit the slice, and thus they may never contribute to the final signal anyway, regardless of the status of their magnetization.

In any MRI application, the acquired image signal is effectively the integral of the signal across the dimensions of each voxel. Thus, in the slice dimension, the signal contribution of the background tissue is effectively the integral of complex magnetization following the pre-saturation pulse (e.g., including T1 relaxation effects during the QI if QISS is used). Therefore, a spatially shaped pre-saturation pulse can be designed in such a way that its spatial profile integrates to null signal while still applying a spatially shaped pre-saturation profile across the slice.

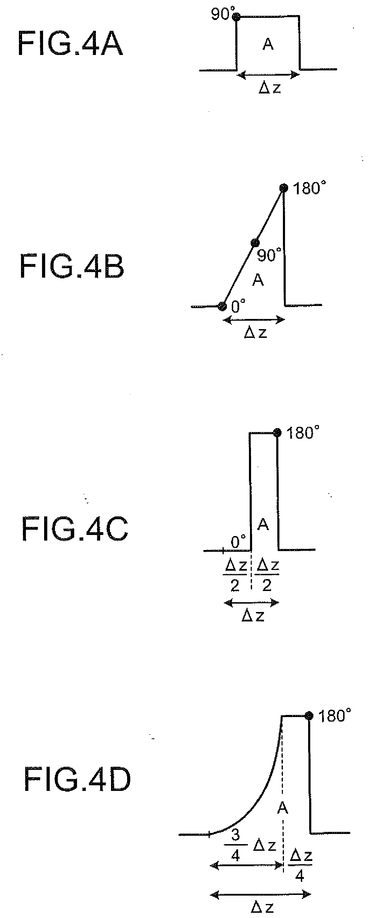

Based on these criteria, many spatially shaped non-uniform pre-saturation pulses can be designed - and some are depicted in FIGS. 4B-4D. Some examples of non-uniform shaping include a linear ramp (FIG. 4B) similar to a TONE RF excitation pulse, a parabolic shape (FIG. 4D) similar to a VUSE (variable angle uniform signal excitation) RF excitation pulse, or a simple half-slice-width rectangular selection (FIG. 4C). The acquisition unit according to the embodiment linearly changes the flip angle of the pre-saturation pulse along the direction in which blood flows (FIG. 4B). The acquisition unit according to the embodiment non-linearly changes the flip angle of the pre-saturation pulse along the direction in which blood flows. For example, the acquisition unit according to the embodiment applies the pre-saturation pulse at a first flip angle (for example, 0°) in a first interval of the slice along the flow direction (for example, 1/2Δz on the left side) and applies the pre-saturation pulse at a second flip angle (for example, 180°) greater than the first flip angle in a second interval (for example, 1/2Δz on the right side) (FIG. 4C). The acquisition unit according to the embodiment applies the pre-saturation pulse while radially increasing the flip angle to a predetermined flip angle (for example, 180°) in the first interval of the slice along the flow direction (for example, 3/4Δz on the left side) and applies the pre-saturation pulse at the predetermined flip angle (for example, 180°) in the second interval (for example, 1/4Δz on the right side) (FIG. 4D). The acquisition unit according to the embodiment changes the flip angle along the flow direction such that the average of flip angles of the pre-saturation pulse is 90°. All of these pulse profiles have the same integrated area. The pulses themselves have been well understood for some time as RF excitation pulses (i.e., an initial NMR excitation part of an MRI data acquisition sequence). However, use of such spatially shaped profile RF pulses as spatially selective pre-saturation RF pulses (e.g., for the purpose of non-contrast in-flow MRA) has now been discovered as a new way to take advantage of their spatially non-uniform shaped selection profiles.

Here, "saturation" is used to confer signal suppression, especially of initial positive magnetization (Mz) in the subsequent image. The spatial pre-saturation pulse is not restricted to a 90° nutation. The spatial pre-saturation pulse will likely include spatial regions where the nutation exceeds 90°. When the effect of the saturation in spatial regions is greater than a 90° nutation, it is still described as saturation as opposed to using the term "inversion." Thus, when a spatial pre-pulse locally has a greater nutation angle, even if that angle exceeds 90°, in these exemplary embodiments, such is described as "greater saturation" compared to lesser RF nutation, even if that lesser nutation is closer to a 90° nutation. Such usage is common in MRI where spatial pulses, chemically selective pre-pulses or the like may often be utilized with nutation angles greater than 90° to accomplish saturation effects within a more complicated pulse sequence.

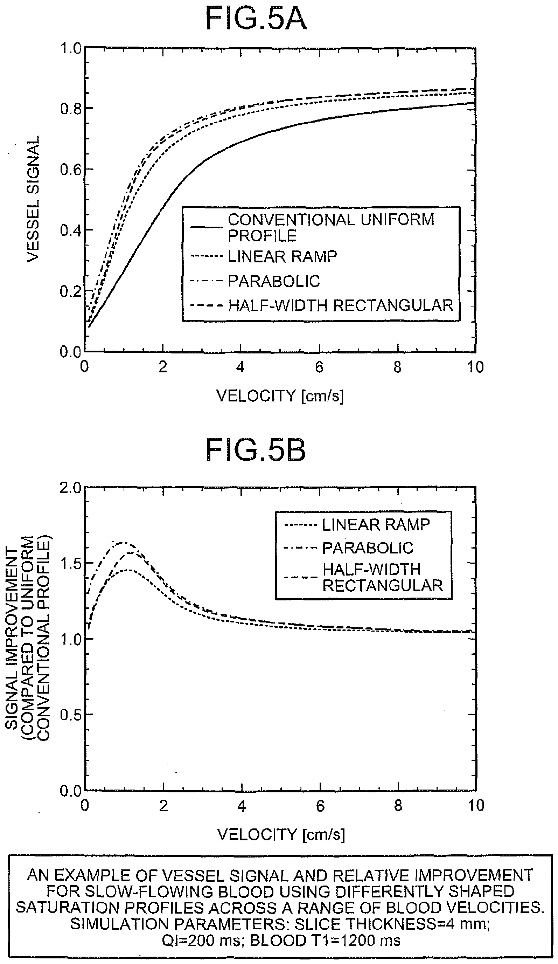

Based on simulations, the non-uniformly shaped pre-saturation pulse greatly increases MRI signal contribution from relatively slow velocity blood as shown in FIGS. 5A-5B. The simulated signal increase is generally between 20- 60%, depending on blood velocity, QI and slice thickness. For fast velocity blood (e.g., peak velocity > 10 cm/s), non-uniformly shaped pre-saturation profiles may offer no relative improvement as almost all of the blood has been refreshed during QI.

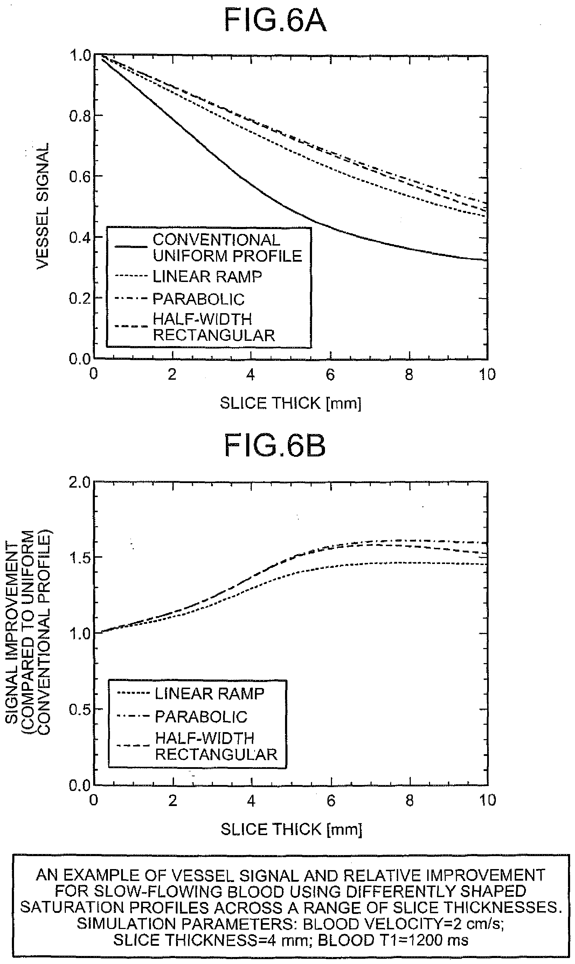

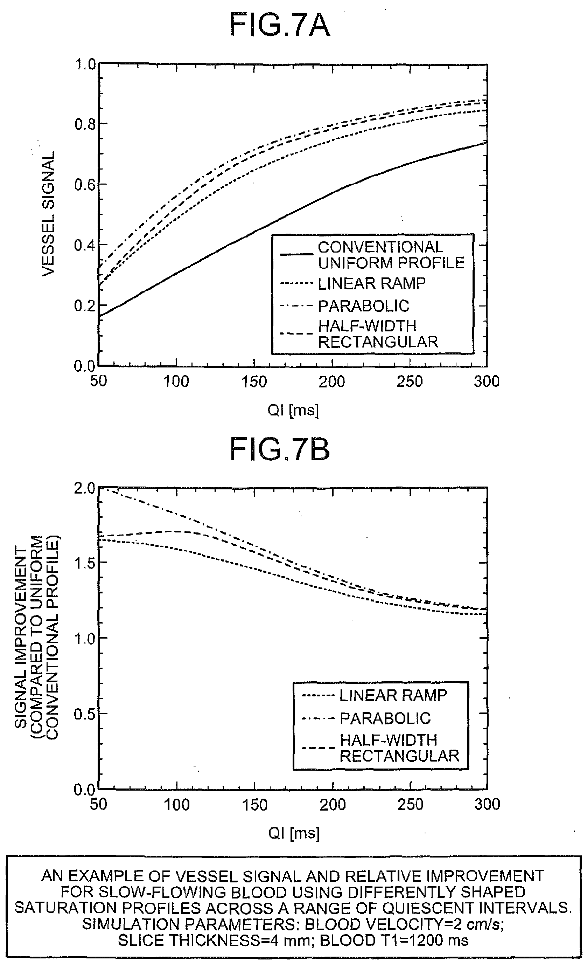

However, by using a non-uniformly shaped pre-saturation pulse, a QISS data acquisition scan (as depicted schematically in FIG. 2) can become less sensitive to the choice of critical parameters such as slice thickness and QI. With non-uniformly shaped pre-saturation pulses, the slice of interest may be thickened to increase SNR and/or save scan time as depicted in FIGS. 6A-6B. Likewise, non-uniformly shaped pre-saturation pulses relieve the burden of QI selection and also generate more robust signals, even for slow-flowing spins, across a wide range of QI as depicted in FIGS. 7A-7B.

The use of a non-uniformly shaped pre-saturation pulse can make the vessel signal largely independent of blood velocity (e.g., see FIGS. 5A-5B). Thus, a QISS data acquisition scan can become less sensitive to cardiac phase - and it may become less necessary to scan during the period of fastest arterial blood flow. By relaxing dependence on cardiac timing, it may even be possible to execute a QISS data acquisition scan ungated, thus further saving scan time and lessening set-up complication.

A QISS sequence was implemented on a research 3T scanner. The arterial trifurcation area was examined on a healthy volunteer using (a) a conventional uniformly shaped rectangular-profile pre-saturation pulse, and then (b) a non-uniform ramp-shaped pulse. In this case, the ramp-shaped pulse had a minimum flip angle of 45° on the in-flow edge and a maximum flip angle of 135° on the out-flow edge.

The following parameters were used: single shot SSFP, TE/TR = 2.3 / 4.6 ms, readout BW = 651 Hz / pixel, FOV = 18 × 30 cm, matrix = 160 x 256, partial Fourier matrix factor = 0.625, slice thickness / gap = 4.0 / -1.5 (net = 2.5), flip angle = 60°, 40 slices, FatSat, Ql = 230 ms, walking pre-saturation (for venous suppression), PPG gating (delay = 450 ms based on empirical measurement). In both cases, the average flip angle across the saturation profile was 90°.

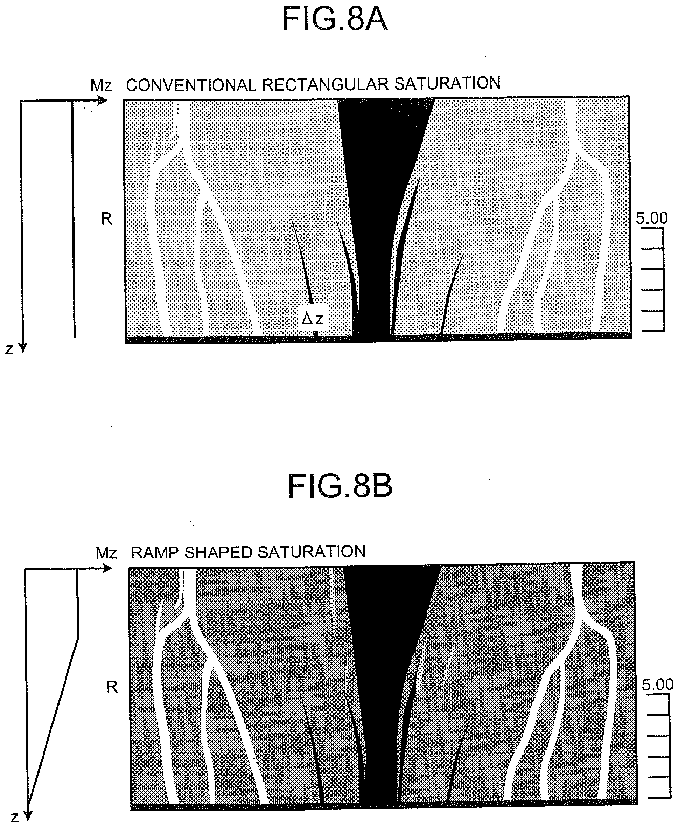

There was limited difference between QISS results with uniform rectangular vs. non-uniform ramp-shaped pre-saturation as shown by comparing FIGS. 8A and 8B. This result is mostly due to the generally fast systolic flow in the trifurcation area (> 10 cm/s). Also, the slope of the ramp was mild (45° to 135°). There is slightly greater background suppression in the ramp shaped data, although this could be caused by small variation in the actual average flip angle. At the prevalent T1 of ∼800 ms (muscle), a slightly higher average flip angle might result in slightly improved background suppression.

In any event, these results confirm that the shaped saturation profile produces desired integrated saturation across the selected slice, even though the saturation flip angle across the slice was non-uniform.

FIGS. 8A and 8B compare conventional uniform rectangular saturation profile (left) vs. ramp shaped pre-saturation profile (right) for relatively fast flow arteries (the trifurcation) where major improvement for extremely slow blood flows was not expected. The images are coronal plane MIP's of QISS multi-slice data. An illustration of the saturation profile shape is given on each image (the slice thickness is exaggerated for demonstration purposes). The slice direction is indicated by the arrow.

The mode of operation for exemplary embodiments is simple. The spatial pre-saturation pulse shape, which is typically a conventional uniform rectangular shaped profile, is replaced with a non-uniformly shaped spatial profile pre-saturation pulse. The non-uniform profile shape can be designed to maximize MRI signal from in-flowing nuclei based on parameters such as flow velocity, slice thickness and in-flow time (QI). Some suggested non-uniform saturation profiles are diagrammed in FIGS. 4B-4D. The detailed design of such slice pre-saturation profiles can be generated using a number of well-known methods.

The average flip angle of the saturation profile is a free parameter. However, as is known, a flip angle of 90° has an advantage in being robust with respect to gating variations (i.e., R-R interval fluctuations in EKG signal due to arrhythmia).

Various MRA and/or MRV pulse sequences (e.g., the QISS technique) are already established. However, using a non-uniform pre-saturation spatial profile should offer improvement - e.g., such as for a critical aspect of the QISS technique like the pre-saturation RF pulse and its associated in-flow period.

The exemplary non-uniformly shaped pre-saturation profile techniques can increase signal from slow-flowing spins (e.g., velocity < 10 cm/s). By this same mechanism, the shaped pre-saturation profile better maintains vessel signal for short post-saturation delays (QI) or thick slices. Since the non-uniformly shaped pre-saturation profile makes QISS less sensitive to flow velocity, the QISS application becomes more robust to variations in flow velocity, including arrhythmia.

Although the spatially non-uniform flip angle of the pre-saturation pulse can result in greater specific absorption rate (SAR) (e.g., because SAR is proportional to the square of the flip angle, the SAR of a non-uniform profile will be greater than a uniform rectangular shaped pulse), the SAR contribution of the pre-saturation pulse is only a fraction of the overall SAR of a complete sequence (which is dominated by the RF excitation pulse).

If there is heterogeneous distribution of materials with different T1 (fat/muscle/fluid) within a slice, the non-uniform flip angle profile of the shaped pre-saturation pulse can produce non-uniform saturation. Since the total saturation of the slice is the integral of NMR magnetization across the slice, depending on the delay time (QI), a non-uniform flip angle applied to heterogeneous T1 can possibly produce greater background signal than a uniform flip angle applied to heterogeneous T1. However, since the slices are typically thin (< 5 mm) and the adjacent tissue generally homogeneous (fat or muscle), this is a negligible issue, as demonstrated by FIGS. 8A-8B.

The exemplary embodiments use a shaped profile selection pulse as a pre-saturation pulse. Modifying the saturation profile selectively enhances velocity-dependent signal from in-flowing spins.

A magnetic resonance imaging (MRI) system is used to produce an image representative of the vasculature of a subject by applying a non-contrast MRI pulse sequence to acquire MRI k-space data from non-stationary nuclei flowing in a selected spatial region of a subject after nuclei within the region have been subjected to spatially non-uniform pre-saturation of nuclear magnetic resonance (NMR) magnetization. Such pre-saturation suppresses subsequent MRI signals emanating from background nuclei located within said region during said pre-saturation, while enhancing MRI signal from flowing nuclei therewithin as a function of speed, slice thickness and elapsed time until image capture as a function of the spatially shaped profile of non-uniform pre-saturation across the imaged volume. Thus, acquired MRI k-space data can then be used to reconstruct an image representing vasculature of the subject.

According to a magnetic resonance imaging apparatus and a magnetic resonance imaging method of at least one embodiment described above, it becomes possible to acquire an appropriate image of vasculature.

While certain embodiments of the inventions have been described, these embodiments have been presented by way of example only, and are not intended to limit the scope of the inventions. Indeed, the novel methods and systems described herein may be embodied in a variety of other forms. Furthermore, various omissions, substitutions and changes in the form of the methods and systems described herein may be made. The accompanying claims and their equivalents are intended to cover such forms or modifications as would fall within the scope of the invention as defined by the claims.

## Claims

1. A magnetic resonance imaging apparatus adapted to produce an image representative of the vasculature of a subject, the apparatus comprising:
a Gₓ, G_{y} and G_{z} gradient coil set (14) connected to Gₓ, G_{y} and G_{z} gradient coil drivers (32);
a RF coil (16) connected to a RF transmitter (34) and a receiver (40) via a transmit/receive switch (36);
a data processor (42);
an MRI sequence controller (30) that has access to an MRI data acquisition program code structure (38) for implementing MRI data acquisition sequences;
the MRI sequence controller (30) configured to, by executing the program code structure (38) control the Gₓ, G_{y} and G_{z} gradient coil drivers (32) and the RF transmitter (34) and the transmit/receive switch (36) to apply to an image slice of interest within the subject a spatially selective saturation pulse that saturates longitudinal magnetization of protons present in the slice of interest; and
the MRI sequence controller (30) further configured to, by executing the program code structure (38) acquire non-contrast MRI signals from the slice of interest by applying an excitation pulse to the slice of interest when a predetermined time has passed after the application of the saturation pulse;
wherein the MRI sequence controller (30) is further configured to orient the slice of interest relative to the vasculature in such a manner that the slice of interest has an inflow edge through which blood flows into the slice of interest and an outflow edge through which blood flows out of the slice of interest, the inflow and outflow edges located opposite of each other across the slice of interest, and
wherein the data processor (42) is configured to reconstruct an image of the vasculature by using the acquired MRI signals and an image reconstruction program (44);
**CHARACTERISED IN THAT**:
the saturation pulse has a spatial profile that provides less saturation at the inflow edge and greater saturation at the outflow edge by providing a smaller nutation angle to any protons at the inflow edge than to any protons near at the outflow edge.

2. The magnetic resonance imaging apparatus according to claim 1, wherein the MRI sequence controller (30) is configured to spatially non-uniformly apply the saturation pulse to the slice of interest by linearly changing the flip angle of the saturation pulse along the blood flow direction.

3. The magnetic resonance imaging apparatus according to claim 1, wherein the MRI sequence controller (30) is configured to spatially non-uniformly apply the saturation pulse to the slice of interest by non-linearly changing the flip angle of the saturation pulse along the blood flow direction.

4. The magnetic resonance imaging apparatus according to claim 3, wherein the MRI sequence controller (30) is configured to apply the saturation pulse at a first flip angle in a first interval of the slice of interest along the blood flow direction and to apply the saturation pulse at a second flip angle greater than the first flip angle in a second interval.

5. The magnetic resonance imaging apparatus according to claim 3, wherein the MRI sequence controller (30) is configured to apply the saturation pulse while radially increasing the flip angle to a predetermined flip angle in a first interval of the slice of interest along the blood flow direction and to apply the saturation pulse at the predetermined flip angle in a second interval.

6. The magnetic resonance imaging apparatus according to claim 1, wherein the MRI sequence controller (30) is configured to spatially non-uniformly apply the saturation pulse to the slice of interest by changing the flip angle of the saturation pulse along the blood flow direction such that the average of flip angles of the saturation pulse is 90°.

7. The magnetic resonance imaging apparatus according to any one of claims 1 to 6, wherein the MRI sequence controller (30) is configured to acquire the signal from the slice of interest by using a QISS, i.e. a quiescent interval single shot, sequence including the saturation pulse.

8. A magnetic resonance imaging method adapted to produce an image representative of the vasculature of a subject, the method comprising:
applying to an image slice of interest within the subject a spatially selective saturation pulse that saturates longitudinal magnetization of all protons in the slice of interest; and
acquire non-contrast MRI signals from the slice of interest by applying an excitation pulse to the slice of interest when a predetermined time has passed after the application of the saturation pulse; wherein the slice of interest is oriented relative to the vasculature in such a manner that the slice of interest has an inflow edge through which blood flows into the slice of interest and an outflow edge through which blood flows out of the slice of interest, the inflow and outflow edges located opposite of each other across the slice of interest; reconstructing an image of the vasculature using the acquired signals and an image reconstruction program (44);
**CHARACTERISED in that**:
the saturation pulse has a spatial profile that provides less saturation at the inflow edge and greater saturation at the outflow edge by providing a smaller nutation angle to any protons at the inflow edge than to any protons at the outflow edge.

## Patentansprüche

1. Magnetresonanzbildgebungsvorrichtung, die angepasst ist, ein Bild zu produzieren, das für die Blutgefäße eines Patienten repräsentierend ist, wobei die Vorrichtung Folgendes umfasst:
einen Satz Gₓ-, G_{y}- und G_{z}-Gradientenspulen (14), die mit Gₓ-, G_{y}- und G_{z}-Gradientenspulentreibern (32) verbunden sind;
eine HF-Spule (16), die via einen Sende-/Empfangsschalter (36) mit einem HF-Sender (34) und einem Empfänger (40) verbunden ist;
einen Datenprozessor (42);
eine MRI-Sequenzsteuerung (30), die zum Implementieren von MRI-Datenerfassungssequenzen Zugriff auf eine MRI-Datenerfassungsprogrammcodestruktur (38) hat;
wobei die MRI-Sequenzsteuerung (30) dazu ausgelegt ist, durch Ausführen der Programmcodestruktur (38) die Gₓ-, G_{y}- und G_{z}-Gradientenspulentreiber (32) und den HF-Sender (34) und den Sende-/Empfangsschalter (36) zu steuern, um an eine Bildscheibe von Interesse im Patienten einen räumlich selektiven Sättigungsimpuls anzulegen, der eine Längsmagnetisierung von Protonen, die in der Scheibe von Interesse vorhanden sind, sättigt; und
wobei die MRI-Sequenzsteuerung (30) ferner dazu ausgelegt ist, durch Ausführen der Programmcodestruktur (38) durch Anlegen eines Erregungsimpulses an die Scheibe von Interesse, wenn nach dem Anlegen des Sättigungsimpulses eine vorbestimmte Zeit vergangen ist, kontrastlose MRI-Signale von der Scheibe von Interesse zu erfassen;
wobei die MRI-Sequenzsteuerung (30) ferner dazu ausgelegt ist, die Scheibe von Interesse in einer Weise relativ auf die Blutgefäße auszurichten, dass die Scheibe von Interesse eine Einströmkante aufweist, durch die Blut in die Scheibe von Interesse fließt, und eine Ausströmkante, durch die Blut aus der Scheibe von Interesse fließt, wobei die Einström- und die Ausströmkante sich über die Scheibe von Interesse einander gegenüber befinden, und
wobei der Datenprozessor (42) dazu ausgelegt ist, durch Verwenden der erfassten MRI-Signale und eines Bildrekonstruktionsprogramms (44) ein Bild von den Blutgefäßen zu rekonstruieren;
**dadurch gekennzeichnet, dass**:
der Sättigungsimpuls ein räumliches Profil aufweist, das durch Bereitstellen eines kleineren Nutationswinkels für Protonen an der Einströmkante als für Protonen nahe an der Ausströmkante an der Einströmkante eine geringere Sättigung und an der Ausströmkante eine größere Sättigung bereitstellt.

2. Magnetresonanzbildgebungsvorrichtung nach Anspruch 1, wobei die MRI-Sequenzsteuerung (30) dazu ausgelegt ist, durch lineares Ändern des Flipwinkels des Sättigungsimpulses entlang der Blutflussrichtung den Sättigungsimpuls räumlich ungleichmäßig an die Scheibe von Interesse anzulegen.

3. Magnetresonanzbildgebungsvorrichtung nach Anspruch 1, wobei die MRI-Sequenzsteuerung (30) dazu ausgelegt ist, durch nichtlineares Ändern des Flipwinkels des Sättigungsimpulses entlang der Blutflussrichtung den Sättigungsimpuls räumlich ungleichmäßig an die Scheibe von Interesse anzulegen.

4. Magnetresonanzbildgebungsvorrichtung nach Anspruch 3, wobei die MRI-Sequenzsteuerung (30) dazu ausgelegt ist, den Sättigungsimpuls in einem ersten Intervall der Scheibe von Interesse in einem ersten Flipwinkel entlang der Blutflussrichtung anzulegen und den Sättigungsimpuls in einem zweiten Intervall in einem zweiten Flipwinkel, der größer ist als der erste Flipwinkel, anzulegen.

5. Magnetresonanzbildgebungsvorrichtung nach Anspruch 3, wobei die MRI-Sequenzsteuerung (30) dazu ausgelegt ist, den Sättigungsimpuls in einem ersten Intervall der Scheibe von Interesse entlang der Blutflussrichtung anzulegen, während der Flipwinkel radial auf einen vorbestimmten Flipwinkel erhöht wird, und den Sättigungsimpuls in einem zweiten Intervall im vorbestimmten Flipwinkel anzulegen.

6. Magnetresonanzbildgebungsvorrichtung nach Anspruch 1, wobei die MRI-Sequenzsteuerung (30) dazu ausgelegt ist, durch Ändern des Flipwinkels des Sättigungsimpulses entlang der Blutflussrichtung derart, dass der Durchschnitt von Flipwinkeln des Sättigungsimpulses 90° beträgt, den Sättigungsimpuls räumlich ungleichmäßig an die Scheibe von Interesse anzulegen.

7. Magnetresonanzbildgebungsvorrichtung nach einem der Ansprüche 1 bis 6, wobei die MRI-Sequenzsteuerung (30) dazu ausgelegt ist, das Signal von der Scheibe von Interesse unter Verwendung einer QISS-Sequenz (Quiescent Interval Single Shot), die den Sättigungsimpuls beinhaltet, zu erfassen.

8. Magnetresonanzbildgebungsverfahren, das angepasst ist, ein Bild zu produzieren, das für die Blutgefäße eines Patienten repräsentierend ist, wobei das Verfahren Folgendes umfasst:
Anlegen eines räumlich selektiven Sättigungsimpulses, der eine Längsmagnetisierung von allen Protonen in der Scheibe von Interesse sättigt, an eine Bildscheibe von Interesse im Patienten; und
Erfassen von kontrastlosen MRI-Signalen von der Scheibe von Interesse durch Anlegen eines Erregungsimpulses an die Scheibe von Interesse, wenn nach dem Anlegen des Sättigungsimpulses eine vorbestimmte Zeit vergangen ist;
wobei die Scheibe von Interesse in einer Weise relativ auf die Blutgefäße ausgerichtet ist, dass die Scheibe von Interesse eine Einströmkante aufweist, durch die Blut in die Scheibe von Interesse fließt, und eine Ausströmkante, durch die Blut aus der Scheibe von Interesse fließt, wobei die Einström- und die Ausströmkante sich über die Scheibe von Interesse einander gegenüber befinden;
Rekonstruieren eines Bildes von den Blutgefäßen durch Verwenden der erfassten MRI-Signale und eines Bildrekonstruktionsprogramms (44);
**dadurch gekennzeichnet, dass**:
der Sättigungsimpuls ein räumliches Profil aufweist, das durch Bereitstellen eines kleineren Nutationswinkels für Protonen an der Einströmkante als für Protonen an der Ausströmkante an der Einströmkante eine geringere Sättigung und an der Ausströmkante eine größere Sättigung bereitstellt.

## Revendications

1. Appareil d'imagerie par résonance magnétique apte à produire une image représentative de la vasculature d'un sujet, l'appareil comprenant :
un ensemble de bobines de gradient Gₓ, G_{y} et G_{z} (14) connecté à des pilotes de bobines de gradient Gₓ, G_{y} et G_{z} (32) ;
une bobine RF (16) connectée à un émetteur RF (34) et à un récepteur (40) par l'intermédiaire d'un commutateur d'émission/réception (36) ;
un processeur de données (42) ;
un contrôleur de séquence d'imagerie par résonance magnétique, MRI, (30) qui a accès à une structure de code de programme d'acquisition de données d'imagerie MRI (38) pour mettre en oeuvre des séquences d'acquisition de données d'imagerie MRI ;
le contrôleur de séquence d'imagerie MRI (30) étant configuré de manière à, en exécutant la structure de code de programme (38), commander les pilotes de bobines de gradient Gₓ, G_{y} et G_{z} (32), l'émetteur RF (34) et le commutateur d'émission/réception (36), en vue d'appliquer, à une tranche d'intérêt d'image au sein du sujet, une impulsion de saturation spatialement sélective qui sature une aimantation longitudinale de protons présents dans la tranche d'intérêt ; et
le contrôleur de séquence d'imagerie MRI (30) étant en outre configuré de manière à, en exécutant la structure de code de programme (38), acquérir des signaux d'imagerie MRI sans contraste à partir de la tranche d'intérêt, en appliquant une impulsion d'excitation à la tranche d'intérêt lorsqu'un temps prédéterminé s'est écoulé après l'application de l'impulsion de saturation ;
dans lequel le contrôleur de séquence d'imagerie MRI (30) est en outre configuré de manière à orienter la tranche d'intérêt par rapport à la vasculature de telle sorte que la tranche d'intérêt présente un bord d'entrée à travers lequel le sang circule dans la tranche d'intérêt et un bord de sortie à travers lequel le sang circule hors de la tranche d'intérêt, les bords d'entrée et de sortie étant situés en face l'un de l'autre à travers la tranche d'intérêt ; et
dans lequel le processeur de données (42) est configuré de manière à reconstituer une image de la vasculature en utilisant les signaux d'imagerie MRI acquis et un programme de reconstitution d'image (44) ;
**caractérisé en ce que** :
l'impulsion de saturation présente un profil spatial qui fournit une saturation moindre au niveau du bord d'entrée et une plus grande saturation au niveau du bord de sortie, en fournissant un angle de nutation plus petit à des protons quelconques au niveau du bord d'entrée qu'à des protons quelconques au niveau du bord de sortie.

2. Appareil d'imagerie par résonance magnétique selon la revendication 1, dans lequel le contrôleur de séquence d'imagerie MRI (30) est configuré de manière à appliquer de façon spatialement inhomogène l'impulsion de saturation à la tranche d'intérêt en modifiant linéairement l'angle de bascule de l'impulsion de saturation le long de la direction de flux sanguin.

3. Appareil d'imagerie par résonance magnétique selon la revendication 1, dans lequel le contrôleur de séquence d'imagerie MRI (30) est configuré de manière à appliquer de façon spatialement inhomogène l'impulsion de saturation à la tranche d'intérêt en modifiant non linéairement l'angle de bascule de l'impulsion de saturation le long de la direction de flux sanguin.

4. Appareil d'imagerie par résonance magnétique selon la revendication 3, dans lequel le contrôleur de séquence d'imagerie MRI (30) est configuré de manière à appliquer l'impulsion de saturation à un premier angle de bascule dans un premier intervalle de la tranche d'intérêt le long de la direction de flux sanguin, et à appliquer l'impulsion de saturation à un second angle de bascule supérieur au premier angle de bascule dans un second intervalle.

5. Appareil d'imagerie par résonance magnétique selon la revendication 3, dans lequel le contrôleur de séquence d'imagerie MRI (30) est configuré de manière à appliquer l'impulsion de saturation tout en augmentant radialement l'angle de bascule à un angle de bascule prédéterminé dans un premier intervalle de la tranche d'intérêt le long de la direction de flux sanguin, et à appliquer l'impulsion de saturation à l'angle de bascule prédéterminé dans un second intervalle.

6. Appareil d'imagerie par résonance magnétique selon la revendication 1, dans lequel le contrôleur de séquence d'imagerie MRI (30) est configuré de manière à appliquer de façon spatialement inhomogène l'impulsion de saturation à la tranche d'intérêt en modifiant l'angle de bascule de l'impulsion de saturation le long de la direction de flux sanguin, de sorte que la moyenne des angles de bascule de l'impulsion de saturation est égale à 90°.

7. Appareil d'imagerie par résonance magnétique selon l'une quelconque des revendications 1 à 6, dans lequel le contrôleur de séquence d'imagerie MRI (30) est configuré de manière à acquérir le signal à partir de la tranche d'intérêt en utilisant une séquence QISS (Quiescent-Interval Single Shot), à savoir une séquence d'une seule prise de vue par intervalle de repos, incluant l'impulsion de saturation.

8. Procédé d'imagerie par résonance magnétique apte à produire une image représentative de la vasculature d'un sujet, le procédé comprenant les étapes ci-dessous consistant à :
appliquer, à une tranche d'intérêt d'image au sein du sujet, une impulsion de saturation spatialement sélective qui sature l'aimantation longitudinale de tous les protons dans la tranche d'intérêt ; et
acquérir des signaux d'imagerie MRI sans contraste à partir de la tranche d'intérêt en appliquant une impulsion d'excitation à la tranche d'intérêt lorsqu'un temps prédéterminé s'est écoulé après l'application de l'impulsion de saturation ;
dans lequel la tranche d'intérêt est orientée relativement à la vasculature de telle sorte que la tranche d'intérêt présente un bord d'entrée à travers lequel le sang circule dans la tranche d'intérêt et un bord de sortie à travers lequel le sang circule hors de la tranche d'intérêt, les bords d'entrée et de sortie étant situés en face l'un de l'autre à travers la tranche d'intérêt ;
reconstituer une image de la vasculature en utilisant les signaux acquis et un programme de reconstitution d'image (44) ;
**caractérisé en ce que** :
l'impulsion de saturation présente un profil spatial qui fournit une saturation moindre au niveau du bord d'entrée et une plus grande saturation au niveau du bord de sortie, en fournissant un angle de nutation plus petit à des protons quelconques au niveau du bord d'entrée qu'à des protons quelconques au niveau du bord de sortie.
